# EUROPÄISCHE PATENTSCHRIFT

(11) **EP 2 318 156 B1**
(45) Veröffentlichungstag und Bekanntmachung des Hinweises auf die Patenterteilung: **02.01.2013**
(21) Anmeldenummer: 09776658.8
(22) Anmeldetag: 28.05.2009
(51) Int. Cl.: B08B 15/00, H01L 21/677, F16C 29/00, F16C 29/02, F16C 33/10, F16C 33/66, F16C 29/08

(54) **REINRAUMTAUGLICHE LINEARFÜHRUNG**
LINEAR GUIDE FOR A CLEAN ROOM
GUIDE LINÉAIRE POUR UNE SALLE BLANCHE

(30) Priorität: 31.07.2008 DE 102008035949
(43) Veröffentlichungstag der Anmeldung: 11.05.2011
(73) Patentinhaber: ETEL S. A.., 2112 Môtiers (CH)
(72) Erfinder: VOLLUZ, Patrick, CH-2013 Colombier NE (CH); PIAGET, Gentien, CH-2105 Travers (CH); BORDAS, Jean-Yves, F-25300 Doubs (FR)
(74) Vertreter: Pleyer, Hans Anno
(86) Internationale Anmeldenummer: PCT/EP2009/003813
(87) Internationale Veröffentlichungsnummer: WO 2010/012331

(56) Entgegenhaltungen:
- US-A- 5 228 353
- US-A- 5 713 244
- US-A1- 2007 071 372
- US-B1- 6 571 932

## Beschreibung

Die vorliegende Erfindung betrifft eine reinraumtaugliche Linearführung. Solche Linearführungen setzen im Betrieb möglichst wenig Partikel frei, so dass der Reinraum nicht verschmutzt wird.

Die Fertigung von integrierten Schaltkreisen findet heutzutage in sogenannten Reinräumen statt, da die Kontamination eines Wafers selbst mit kleinsten Partikeln bereits zu einem Ausfall der zu fertigenden Schaltkreise führen kann. Für alle in einem Reinraum verwendeten Einrichtungen und Maschinen gilt daher die Forderung, möglichst wenig Partikel zu erzeugen.

Da Wafer während des Fertigungsprozesses bewegt werden müssen, kann auf bewegliche Teile nicht verzichtet werden. Die Verwendung von Luftlagern, die berührungslos und damit ohne Abrieb arbeiten, ist aus Kostengründen nicht immer möglich. So werden auch Führungen eingesetzt, die auf herkömmlichen Lagern wie z.B. Kugellager oder Gleitlager beruhen. Auch wenn solche Lager aus besonders abriebarmen Materialien hergestellt werden, lässt sich die Bildung von Partikeln nicht vermeiden. Es sind daher bereits Vorrichtungen bekannt, bei denen mittels einer Absaugung entstandene Partikel abgesaugt werden, bevor sie in die Umgebung gelangen und den Reinraum verschmutzen können.

Die US 4955244 beschreibt beispielsweise einen reinraumtauglichen Apparat mit einem auf einer Kugelumlaufspindel beruhenden Linearantrieb. Am Läufer werden durch eine Öffnung von dessen Gehäuse im Inneren des Gehäuses erzeugte Partikel abgesaugt. Hierzu wird eine Absaugung am Schmiernippel des Gehäuses angebracht.

Das Dokument US 2007/0071372 A1 offenbart eine Linearführung mit allen Merkmalen des Oberbegriffs vom Anspruch 1.

Aufgabe der Erfindung ist es, eine möglichst einfache, stabile und vor allem reinraumtaugliche Lösung für eine Linearführung zu finden, bei der durch Reibung entstehende Partikel abgesaugt werden können.

Diese Aufgabe wird gelöst durch eine Linearführung mit einer Schiene und einem Laufwagen, wobei der Laufwagen mit einer Anwendungsplattform mittels Schrauben verbunden ist. Eine der Schrauben ist eine Vakuumschraube mit einem axialen Kanal, durch den Partikel aus einem Luftspalt zwischen Schiene und Laufwagen absaugbar sind.

Weitere Vorteile sowie Einzelheiten der vorliegenden Erfindung ergeben sich aus der nachfolgenden Beschreibung einer bevorzugten Ausführungsform anhand der Figuren. Dabei zeigt
- Figur 1: eine Linearführung mit Anwendungsplattform,
- Figur 2: eine Schnittansicht zur Figur 1

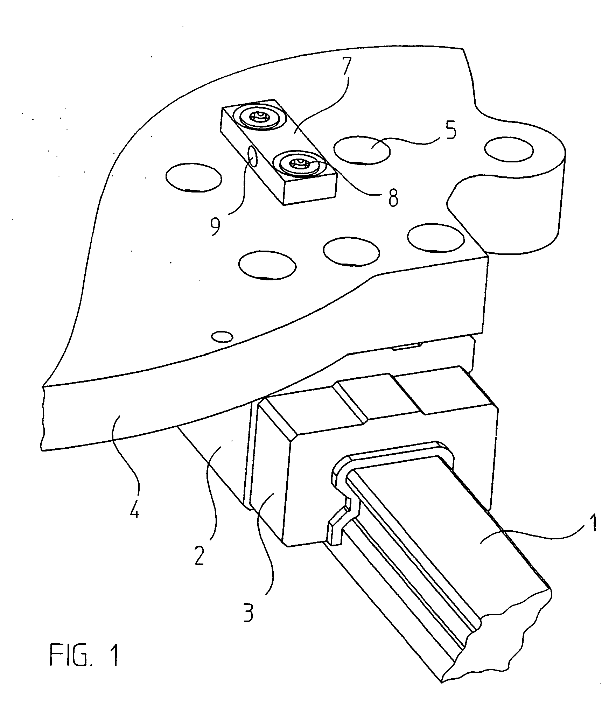

Figur 1 zeigt eine Linearführung mit einer Schiene 1, auf der ein Laufwagen 2 linear beweglich gelagert ist. Für spezielle Anwendungen kann die Schiene 1 auch gebogen sein, so dass der Laufwagen 2 rollende, gierende oder nickende Bewegungen ausführen kann. Der Laufwagen 2 weist an beiden Enden eine Abdeckung 3 auf, die den Luftspalt zwischen der Schiene 1 und dem Laufwagen 2 möglichst gut abschließt. Das Austreten von durch Abrieb erzeugten Partikeln ist so erschwert. Eine Anwendungsplattform 4, im Folgenden auch einfach als Tisch 4 bezeichnet, ist mit dem Laufwagen 2 verbunden, so dass der Tisch 4 selbst linear beweglich ist. Der Tisch 4 kann dabei durchaus von mehreren parallelen Linearführungen gehalten werden, oder auch von zwei oder mehr Laufwagen 2, die auf einer gemeinsamen Schiene 1 laufen.

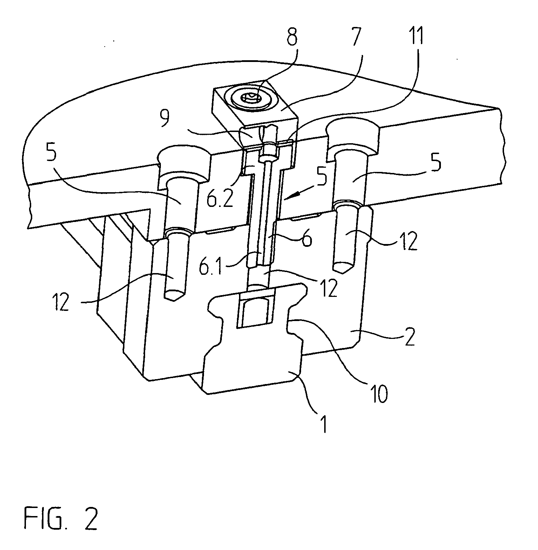

Die Details der Verbindung des Tisches 4 mit dem Laufwagen 2 sind in der Schnittzeichnung der Figur 2 dargestellt.

Im Schnitt erkennt man drei den Tisch 4 durchdringende Bohrungen 5. Am Laufwagen 2 sind korrespondierende Bohrungen 12 mit einem Innengewinde vorgesehen. Mittels Schrauben 6 (in der Figur 2 ist nur die mittlere Schraube dargestellt) kann der Tisch 4 mit dem Laufwagen 2 verbunden werden.

Die mittlere der drei Bohrungen 12 im Laufwagen 2 endet im Luftspalt zwischen dem Laufwagen 2 und der Schiene 1, vorzugsweise wie dargestellt mittig und oberhalb der Schiene 1. Da in solchen Linearführungen Kugeln oder Rollen üblicherweise an den beiden Seiten der Linearführung laufen, und die Schiene 1 an ihrer der mittleren der drei Bohrungen 12 gegenüberliegenden oberen Fläche selbst Öffnungen mit Schrauben zum Befestigen der Schiene 1 auf einem Untergrund aufweist, stört diese Bohrung 12 oberhalb der Schiene 1 nicht den Betrieb der Linearführung.

In die mittleren Bohrungen 5, 12 von Tisch 4 und Laufwagen 2 wird eine Vakuumschraube 6 eingesetzt. Solche Vakuumschrauben 6 werden üblicherweise in der Vakuumtechnik verwendet, um nicht beim Eindrehen einer Schraube ein isoliertes Luftreservoir zu erzeugen, das beim Abpumpen der Umgebungsluft langsam Luft abgeben und somit das Vakuum verschlechtern würde.

Gemäß dieser Erfindung wird die Vakuumschraube 6 in einer völlig anderen Funktion eingesetzt. Zu einem Teil trägt sie zur Verbindung von Tisch 4 und Laufwagen 2 bei, auch wenn die in den äußeren Bohrungen 5, 12 eingesetzten herkömmlichen Schrauben ein deutlich höheres Anzugsmoment aufbringen können. Vor allem aber erlaubt die Vakuumschraube 6 das Absaugen von Partikeln aus dem Luftspalt zwischen Schiene 1 und Laufwagen 2.

Vakuumschrauben verfügen nämlich über einen Kanal 6.1, über den erfindungsgemäß die Partikel absaugbar sind. Die Vakuumschraube 6 weist hierzu eine axiale, über die gesamte Länge der Vakuumschraube 6 erstreckte Bohrung mit einem Durchmesser von etwa einem halben Millimeter auf. Alternativ kann die Vakuumschraube 6 auch eine seitliche Kerbe aufweisen, durch die Luft und Partikel absaugbar sind.

Oberhalb der Vakuumschraube 6 ist ein Anschlussstück 7 zu erkennen, das mit Schrauben 8 am Tisch 4 befestigt ist. Das Anschlussstück 7 weist eine Öffnung 9 für eine Vakuumzuführung auf. Diese Vakuumzuführung ist im Inneren des Anschlussstücks mit dem Kanal 6.1 der Vakuumschraube 6 verbunden. Hierzu ist zwischen dem Anschlussstück 7 und dem Kopf 6.2 der Vakuumschrauben ein Dichtring 11 eingesetzt, der für eine dichte Verbindung zwischen Anschlussstück 7 und Vakuumschraube 6 sorgt.

Wird nun eine Absaugung mit dem Anschlussstück 7 verbunden, so wird ein Luftstrom und damit ein Unterdruck im Laufwagen 2 erzeugt, die dafür sorgen, dass zwischen der Abdeckung 3 des Laufwagens 2 und der Schiene 1 keine Partikel mehr entweichen können, da dort ein Luftstrom ins Innere des Laufwagens 2 entsteht. Partikel im Inneren des Laufwagens werden außerdem durch den Kanal 6.1 der Vakuumschraube 6 und das Anschlussstück 7 abgesaugt. Sie können sich also nicht im Inneren des Laufwagens anreichern. Die mit den Partikeln kontaminierte Abluft kann außerdem problemlos gefiltert werden und / oder außerhalb des Reinraums entweichen. Die Umgebung der Linearführung ist somit optimal vor den durch Abrieb in der Linearführung entstehenden Partikeln geschützt.

Da ein einzelner Laufwagen 2 auch mit zwei oder mehr in Laufrichtung versetzten Vakuumschrauben befestigt werden kann, und der Tisch 4 auf mehreren Laufwagen befestigt sein kann, ist es vorteilhaft, wenn der Tisch 4 einen Vakuumanschluss aufweist, von dem aus über sich verzweigende Vakuumschläuche die Absaugung an die Anschlussstücke 7 verteilt wird. Diese Verteilung kann dabei ebenso im inneren des Tisches angeordnet sein wie die Anschlussstücke 7 selbst, so dass der Tisch 4 anwendungsseitig eine plane Oberfläche aufweist.

Als Antrieb für den Laufwagen 2 bzw. den Tisch 4 eigenen sich besonders sogenannte Direktantriebe wie z.B. Linearmotoren oder Torquemotoren, bei denen ein Primärteil mit Spulen einem Sekundärteil mit einer Reihe von Magneten gegenüberliegt, die mit abwechselnder Polarität angeordnet sind. Solche Direktantriebe weisen kein Getriebe auf benötigen keine eigenen Lager. Solche zusätzlich Partikel produzierende Bestandteile können mit Direktantrieben also vermieden werden.

Primärteil und Sekundärteil werden von der Linearführung mit der erfindungsgemäßen Absaugung der Partikel gegeneinander beweglich gehalten, indem z.B. das Primärteil mit dem Laufwagen 2 oder dem Tisch 4 verbunden ist, und das Sekundärteil mit der Schiene 1 oder dem Untergrund, auf dem auch die Schiene 1 befestigt ist.

## Patentansprüche

1. Linearführung mit einer Schiene (1) und einem Laufwagen (2), wobei der Laufwagen (2) mit einer Anwendungsplattform (4) mittels Schrauben (6) verbunden ist, **dadurch gekennzeichnet, dass** wenigstens eine der Schrauben (6) eine Vakuumschraube mit einem axialen Kanal (6.1) ist, durch den Partikel aus einem Luftspalt (10) zwischen Schiene (1) und Laufwagen (2) absaugbar sind.

2. Linearführung nach Anspruch 1, **dadurch gekennzeichnet, dass** ein Anschlussstück (7) mit einer Öffnung (9) für eine Vakuumzuführung so auf der Anwendungsplattform (4) befestigt ist, dass die Öffnung (9) dicht mit dem Kanal (6.1) verbunden ist.

3. Linearführung nach Anspruch 2, **dadurch gekennzeichnet, dass** zwischen dem Anschlussstück (7) und der Vakuumschraube (6) eine Dichtung (11) angeordnet ist.

4. Linearführung nach Anspruch 3, **dadurch gekennzeichnet, dass** die Dichtung (11) aus einem Dichtring besteht, der zwischen einem Kopf (6.2) der Vakuumschraube (6) und dem Anschlussstück (7) eingeklemmt ist.

5. Linearführung nach Anspruch 1, **dadurch gekennzeichnet, dass** die Vakuumschraube (6) in einer Bohrung (12) des Laufwagens (2) sitzt, die im Luftspalt (10) zwischen der Schiene (1) und dem Laufwagen (2) endet.

6. Linearführung nach Anspruch 5, **dadurch gekennzeichnet, dass** der Laufwagen (2) Abdeckungen (3) aufweist, die den Luftspalt zwischen der Schiene (1) und dem Laufwagen (2) abdecken.

7. Linearführung nach einem der vorhergehenden Ansprüche, **dadurch gekennzeichnet, dass** die Linearführung ein Primärteil und ein Sekundärteil eines Direktantriebes gegeneinander beweglich hält.

## Claims

1. Linear guide having a rail (1) and a carriage (2), the carriage (2) being connected to a use platform (4) by means of screws (6), **characterized in that** at least one of the screws (6) is a vacuum screw with an axial channel (6.1), through which particles can be extracted by suction from an air gap (10) between the rail (1) and the carriage (2).

2. Linear guide according to Claim 1, **characterized in that** a connection piece (7) with an opening (9) for a vacuum supply means is fastened to the use platform (4) in such a way that the opening (9) is connected in an airtight manner to the channel (6.1).

3. Linear guide according to Claim 2, **characterized in that** a seal (11) is arranged between the connection piece (7) and the vacuum screw (6).

4. Linear guide according to Claim 3, **characterized in that** the seal (11) comprises a sealing ring which is clamped in between a head (6.2) of the vacuum screw (6) and the connection piece (7).

5. Linear guide according to Claim 1, **characterized in that** the vacuum screw (6) is seated in a bore (12) of the carriage (2), which bore (12) ends in the air gap (10) between the rail (1) and the carriage (2).

6. Linear guide according to Claim 5, **characterized in that** the carriage (2) has covers (3) which cover the air gap between the rail (1) and the carriage (2).

7. Linear guide according to one of the preceding claims, **characterized in that** the linear guide keeps a primary part and a secondary part of a direct drive movable with respect to one another.

## Revendications

1. Guide linéaire comprenant un rail (1) et un chariot (2), le chariot (2) étant relié à une plate-forme d'utilisation (4) au moyen de vis (6), **caractérisé en ce qu'**au moins l'une des vis (6) est une vis à vide dotée d'un canal axial (6.1) à travers lequel des particules peuvent être aspirées hors d'un espace d'air (10) entre le rail (1) et le chariot (2).

2. Guide linéaire selon la revendication 1, **caractérisé en ce qu'**une pièce de raccordement (7) dotée d'une ouverture (9) pour une alimentation en vide est fixée à la plate-forme d'utilisation (4) de telle sorte que l'ouverture (9) est reliée de manière étanche au canal (6.1)

3. Guide linéaire selon la revendication 2, **caractérisé en ce qu'**un joint d'étanchéité (11) est disposé entre la pièce de raccordement (7) et la vis à vide (6).

4. Guide linéaire selon la revendication 3, **caractérisé en ce que** le joint d'étanchéité (11) est constitué d'une bague d'étanchéité qui est serrée entre une tête (6.2) de la vis à vide (6) et la pièce de raccordement (7).

5. Guide linéaire selon la revendication 1, **caractérisé en ce que** la vis à vide (6) est placée dans un alésage (12) du chariot (2), lequel alésage se termine dans l'espace d'air (10) entre le rail (1) et le chariot (2).

6. Guide linéaire selon la revendication 5, **caractérisé en ce que** le chariot (2) comprend des couvercles (3) qui recouvrent l'espace d'air entre le rail (1) et le chariot (2).

7. Guide linéaire selon l'une quelconque des revendications précédentes, **caractérisé en ce que** le guide linéaire maintient une partie primaire et une partie secondaire d'un entraînement direct mobiles l'une par rapport à l'autre.
